# EUROPEAN PATENT APPLICATION

(11) **EP 1 137 328 A2**
(43) Date of publication of application: **26.09.2001**
(21) Application number: 00116699.0
(22) Date of filing: 02.08.2000
(51) Int. Cl.: H05K 1/03

(54) **Insulating material for printed wiring board**

(30) Priority: 24.03.2000 JP 2000083554
(71) Applicant: Matsushita Electric Works, Ltd., Kadoma-shi, Osaka (JP); Arakawa Chemical Industries, Ltd., Osaka-shi, Osaka 541-0046 (JP)
(72) Inventor: Saito, Eiichiro,, Kadoma-shi, Osaka (JP); Shinotani, Ken-ichi, Kadoma-shi, Osaka (JP); Komori, Kiyotaka, Kadoma-shi, Osaka (JP); Goda, Hideki, c/o Arakawa Chemical Industries, Ltd, Jyoto-Ku Osaka (JP); Higashino, Tetsuji,, Jyoto-Ku Osaka (JP)
(74) Representative: Pfenning, Meinig & Partner

(57) **Abstract**

An insulating material for printed wiring boards characterized by comprising: a silane modified resin composition containing an alkoxy-group containing silane modified resin obtained by a reaction between a hydroxyl-group containing resin (1) that is at least one kind selected from the group consisting of a hydroxyl-group containing epoxy resin (A) and a phenolic resin (B) and an alkoxysilane partial condensate (2).

## Description

### TECHNICAL FIELD

The present invention relates to an insulating material for printed wiring boards in which a silane modified resin composition is used.

### PRIOR ART

Conventionally, printed wiring boards have been used in various fields such as electric appliances, electronic apparatuses, communication apparatuses, computers, etc., and along with the recent rapid development of electronic techniques, there have been ever-increasing demands for high performance of insulating materials for printed wiring boards.

With respect to insulating materials used for printed wiring boards, various materials, such as conventional prepreg and copper-clad laminates, resin coated copper foil for build-up wiring boards and insulating sheets, have been adopted. Moreover, with respect to an insulating film interpolated between semiconductor layers, etc., there have been increasing demands for high performances as insulating materials.

With respect to specific requirements for high performances of these insulating materials for printed wiring boards, high heat resistance, low thermal expansion property, low dielectric constant and low dissipation factor tangent are listed. High heat resistance is required because reflow temperatures become higher at the time of packaging due to Pb-free solder used at the time of packaging, and because larger parts have come to be used so that distortion, etc. in the substrate at the time of packaging tend to cause defects in connection at the time of packaging. Low thermal expansion property is required because larger parts have come to be used so that heat history during service tends to cause degradation in the conductor pattern and the resulting disconnection. Low dielectric constant is essential in eliminating delays in signal speeds in highfrequency areas and
in controlling impedance, and low dissipation factor tangent is also essential in preventing attenuation in signals.

With respect to high heat resistant resins that meet the demand for high heat resistance, polyimide resins and fluororesins are listed; however, these materials have a problem of high costs. Moreover, with respect to methods for ensuring high heat resistance by using inexpensive epoxy resins, a method has been proposed in which an epoxy resin itself or a curing agent thereof is converted to a multi-functional compound. However, these materials have not yet reached a level in heat resistance suitable for practical use. Furthermore, a halogen-based flame retardant is used so as to impart a flame proofing property to printed wiring boards. However, along with the recent environmental problems, one trend in designing resins is to avoid using halogen-based retardants, and this trend has to be taken into consideration.

The present invention has been devised to solve the above-mentioned problems, and its first objective is to provide an insulating material for printed wiring boards which can produce a printed wiring board with high heat resistance by using a specific silane modified resin composition, and its second objective is to provide an insulating material for printed wiring boards which is also superior in low thermal expansion and flame proof.

The present invention relates to an insulating material for printed wiring boards that is characterized by containing a silane modified resin composition containing an alkoxy-group containing silane modified resin (hereinafter, referred to simply as silane modified resin) obtained by a reaction between a hydroxyl-group containing resin (1) that is at least one kind selected from the group consisting of a hydroxyl-group containing epoxy resin (A) and a phenolic resin (B) and an alkoxysilane partial condensate (2).

The hydroxyl-group containing resin (1) of the present invention is at least one kind selected from the group consisting of a hydroxyl-group containing epoxy resin (A) and a phenolic resin (B).

With respect to the hydroxyl-group containing epoxy resin (A), various bisphenol-type epoxy resins may be used. The bisphenol-type epoxy resin is obtained by a reaction between bisphenols and haloepoxides such as epichlorohydrine or β-methylepichlorohydrine. Examples of bisphenols include reactants between phenols or 2,6-dihalophenol and aldehydes or ketones such as formaldehyde, acetaldehyde, acetone, acetphenone, cyclohexanone and benzophenone, and also include reactants obtained through an oxidizing reaction of dihydroxyphenylsulfide by using a peracid and an etherification reaction of hydroquinones and hydrogenated bisphenols obtained by hydrogenating these bisphenols. Moreover, the above-mentioned bisphenols may be obtained by partially substituting the following compounds: 4,4'-dihydroxybiphenyl, trihydroxydiphenyldimethylethane, long-chain bisphenols, resorcinol, saligenin, etc.

Among these bisphenol-type epoxy resins, in particular, bisphenol-A-type epoxy resins derived from bisphenol A are most widely used, and these are preferable because of their low costs.

Moreover, the above-mentioned hydroxyl-group containing epoxy resin (A) has a hydroxyl group that is subjected to an ester-exchange reaction with the alkoxysilane partial condensate (2). The hydroxyl group is not necessarily contained in all the molecules constituting the hydroxyl-group containing epoxy resin (A), and it is only necessary for the hydroxyl-group containing epoxy resin (A) to contain a hydroxyl group. The epoxy equivalent of the hydroxyl-group containing epoxy resin (A) varies depending on the structure of the hydroxyl-group containing epoxy resin (A); and those having an appropriate epoxy equivalent may be preferably selected and used; however, in general, it is preferable to use those having an epoxy equivalent in the range from not less than 180 to not more than 5000. The smaller the epoxy equivalent, the greater the possibility of the resulting silane modified resin becoming a cured cloudy product due to the phase separation between silica and epoxy resin. In contrast, the greater the epoxy equivalent, the greater the possibility of the silane modified resin gelling during the manufacturing processes.

With respect to the phenolic resin (B), novolak phenolic resins, which are obtained by reacting phenols and aldehydes in the presence of an acidic catalyst, are preferable. The novolak phenolic resin has a small phenolic hydroxyl equivalent and is multi-functional so that it increases the number of bonds between silane and hydroxyl groups and allows several hydroxyl groups to remain even after the novolak phenolic resin has been silane-modified, and to still react with other resins; thus, it is possible to obtain high heat resistance and low thermal expansion property. Moreover, with respect to the novolak phenolic resin, in general, it is preferable to use those having an average number of phenolic units of approximately 3 to 8. In the case of the average number of phenolic units of less than 3, it becomes difficult to obtain high heat resistance because of a small number of crosslinking points, and in the case of the average number exceeding 8, it is not preferable because of possible gelation prior to use.

Here, with respect to the phenols, for example, the following various kinds of them are listed: phenol, o-cresol, m-cresol, p-cresol, 2,3-xylenol, 2,4-xylenol, 2,5-xylenol, 2,6-xylenol, 3,4-xylenol, 3,5-xylenol, p-ethylphenol, p-isopropylphenol, p-tertiarybutylphenol, p-chlorophenol, p-bromophenol, etc. With respect to formaldehydes, besides formalin, formaldehyde generating source materials, such as paraformaldehyde, trioxan and tetraoxan, may be used. Moreover, any known acidic catalyst may be used as the above-mentioned acidic catalyst.

Moreover, in the present invention, the alkoxysilane partial condensate (2) is an oligomer obtained by partially hydrolyzing and condensing an alkoxysilane compound represented by a general formula: R1nSi (OR2) 4-n(in the formula, n represents an integer 0 or 1, R1 represents a lower alkyl group and allyl group which are directly connected to a carbon atom, and may be the same group or different groups, and R2 represents a lower alkyl group). In the case of n in the range of 2 to 4, no three-dimensional crosslinking occurs, thereby failing to provide high heat resistance; therefore, this case is not preferable.

With respect to the alkoxysilane compound constituting the alkoxysilane partial condensation compound (2) represented by the above-mentioned general formula, examples thereof include: tetraalkoxysilane, methyltrialkoxysilane, ethyltrialkoxysilane, n-propyltrialkoxysilane, isopropyltrialkoxysilane, phenyltrialkoxysilane, etc. More specifically, methoxysilanes, such as tetramethoxysilane and methyltrimethoxysilane, are preferably used because they have greater ester-exchange reaction speed and setting reaction speed, and also have low costs. Moreover, in an attempt to obtain a low thermal expansion property, it is preferable to use tetraalkoxysilane of n = 0. The reason for this is that this material allows the alkoxysilane compound constituting the alkoxysilane partial condensate (2) to have four functional groups, and consequently to provide a high-ordered silica structure at the time of setting; therefore, it is possible to easily exert high heat resistance originated from the inorganic material. In contrast, in an attempt to reduce the defect of brittleness originated from the inorganic material, it is preferable to add trialkoxysilane of n = 1.

With respect to the alkoxysilane partial condensate (2), one kind or not less than two kinds are properly selected from the above-mentioned materials; and it is preferable to set the average number of Si per molecule in the range of 2 to 20. The average number of Si of not less than two increases the amount of alkoxysilanes that do not react at the time of the ester exchange reaction with the hydroxyl-group containing epoxy resin (A) or the phenolic resin (B), and flow away together with side-produced alcohol, which is not preferable. Moreover, the average number exceeding 20 causes a reduction in the reactivity with these resins, resulting in a difficulty in obtaining the target product, which is not preferable. Therefore, when readiness of synthesis is taken into consideration, the average number of Si per molecule is set in the range of 2 to 20.

The silane modified resin used in the present invention is prepared by allowing the hydroxyl-group containing resin (1) that is at least one kind selected from the group consisting of the hydroxyl-group containing epoxy resin (A) and the phenolic resin (B) and the alkoxysilane partial condensate (2) to undergo an ester exchange reaction. In the case when at the time of this reaction, the hydroxyl-group containing epoxy resin (A) is used as the hydroxyl-group containing resin (1), the ratio of use of the hydroxyl-group containing epoxy resin (A) and the alkoxysilane partial condensate (2) is not particularly limited; however, the ratio (mass ratio) of the mass of the hydrolyzable alkoxysilane partial condensate (2) based upon silica conversion / the mass of the hydroxyl-group containing epoxy resin (A) is preferably set in the range of 0.01 to 1.2. On the other hand, in the case when the phenolic resin (B) is used as the hydroxyl-group containing resin (1), the ratio of use of the phenolic resin (B) and the alkoxysilane partial condensate (2) is also not particularly limited, as long as the ratio is set in such a manner that phenolic hydroxyl groups remain in the resulting silane modified resin. Normally, the ratio (equivalent ratio) of the equivalent of phenolic hydroxyl groups of the phenolic resin (B) / the equivalent of alkoxy groups of the hydrolytic alkoxysilane partial condensate (2) is preferably set in the range of 0.2 to 10. Here, in the case when this equivalent ratio is in the vicinity of 1 (that is, stoichiometrically in the vicinity of equivalent), since the solution becomes susceptible to high viscosity and gellation as the ester exchange reaction progresses, it is necessary to adjust the progress of the ester exchange reaction. Moreover, at the time of the above-mentioned two ester exchange reactions, any of the known ester exchanging catalysts may be used to accelerate the reactions; and for example, an organic metal catalyst is preferably used.

The objective of the above-mentioned reaction is to obtain an alkoxysilyl-group containing silane modified resin by allowing the hydroxyl-group of the hydroxyl-group containing resin (A) and the alkoxysilyl portion of the alkoxysilane partial condensate to undergo an ester exchange reaction, and it is not preferable to generate new siloxane bonds due to condensation between alkoxysilyl portions and further to generate silica skeletons due to the subsequent sol-gel setting at the time of the actual reaction. Therefore, the above-mentioned reaction is preferably carried out virtually in a water-free condition so as not to allow the alkoxysilyl portions to undergo the sol-gel setting reaction.

Moreover, the above-mentioned reaction may be carried out in a solvent. With respect to this solvent, not particularly limited, any organic solvent may be used as long as it dissolves both of the hydroxyl-group containing resin (1) and the alkoxysilane partial condensate (2). With respect to such an organic solvent, for example, non-protic polar solvents, such as dimethylformaldehyde, dimethylacetamide and methylethylketone, may be preferably used.

The silane modified resin thus obtained has a silane modified epoxy resin formed by silane-modifying the hydroxyl group of the hydroxyl-group containing epoxy resin (A) and a silane modified phenolic resin formed by silane-modifying phenolic hydroxyl groups of the phenolic resin (B) as its main components, and the silane modified resin of the present invention features that it has alkoxy groups that are bonded to a number of Si atoms. These alkoxysilyl portions exert a sol-gel reaction or a demethanol condensation reaction under evaporation of the solvents, heating-up or reaction with moisture of manufacturing a prepreg or at the time of manufacturing CCL or resin coated copper foil, and bond with each other to form mesh siloxane bonds (Si-O-Si), thereby forming a cured product having fine silica portions (high-ordered mesh structure of siloxane bonds) in a gelled state. For this reason, the silane modified resin, used in the present invention, is produced by an ester exchange reaction between alkoxy groups of the alkoxysilane partial condensate (2) and hydroxyl groups of the hydroxyl-group containing epoxy resin (A) or phenolic hydroxyl groups of the novolak phenolic resin (B); however, in the case of the silane modified epoxy resin, it is preferable when at least 50%, and more preferably not less than 60%, of alkoxy groups of the alkoxysilane partial condensate (2), are remaining therein. In the case of the silane modified phenolic resin, it is preferable to allow at least 30%, and more preferably not less than 40%, of alkoxy groups of the alkoxysilane partial condensate (2) to remain therein.

Moreover, the silane modified resin, used in the present invention, may contain unreacted hydroxyl-group containing epoxy resin (A) or phenolic resin (B) and unreacted alkoxysilane partial condensate (2), reaction catalyst, reaction solvent, etc.

Here, the unreacted alkoxysilane partial condensate (2) can be bonded to the silane modified resin by the setting reaction to silica at the time of forming the above-mentioned cured product. In order to allow this bonding process to take place, a small amount of water may be contained in the silane modified resin so as to accelerate hydrolysis and condensation.

Moreover, in the case when the hydroxyl-group containing resin (1) is the phenolic resin (B), after having reacted the phenolic resin (B) with the alkoxysilane partial condensate (2), 0.2 to 3 equivalent amounts of water was added to alkoxy groups remaining in the resulting reactant so as to hydrolyze them, and this may be used as the silane modified resin. This method is effective so as to increase the silica setting speed at the alkoxysilyl portion, and in particular, more effective when R2 in the aforementioned general formula is an alkyl group not less than an ethyl group; however, this tends to cause serious degradation in the stability of the silane modified resin.

The silane modified resin composition used in the present invention is prepared as containing a silane modified resin obtained as described above, and the silane modified resin composition only needs to contain not less than 30 weight % (converted based upon non-volatile components) of silane modified resin, and the other components are not particularly limited.

In the case when the silane modified epoxy resin is used as the silane modified resin, any of the known epoxy curing agent, solvent, curing catalyst, etc. may be properly blended so as to form a silane modified resin composition.

Moreover, in the case when a silane modified phenolic resin is used as the silane modified resin, any of the known epoxy resin, solvent, curing catalyst, etc. may be properly blended to form a silane modified phenolic resin composition.

Here, with respect to the epoxy curing agent used in forming the silane modified epoxy resin composition, any curing agent normally used as a curing agent for epoxy resins, for example, a phenolic resin based curing agent, polyamine based curing agent, and polycarboxylic acid anhydride based curing agent, etc. may be used without specific limitations. More specifically, examples of the phenolic resin based curing agent include: phenol novolak resins, bisphenol novolak resins, poly-p-vinylphenol, etc. Examples of the polyamine based curing agent include: diethylenetriamine, triethylenetetramine, tetraethylenepentamine, dicyandiamide, polyamideamine (polyamide resin), ketimine compounds, isophoronediamine, m-xylenediamine, m-phenylenediamine, 1,3-bis(aminomethyl)cyclohexane, N-aminoethylpiperazine, 4,4'-diaminodiphenylmethane, 4,4'-diamino-3,3'-diethyldiphenylmethane, diaminodiphenylsulfone, etc. With respect to the polycarboxylic acid based curing agent, examples thereof include: phthalic anhydride, tetrahydrophthalic anhydride, methyltetrahydrophthalic anhydride, 3,6-endomethylenetetrahydrophthalic anhydride, hexachloroendomethylenetetrahydrophthalic anhydride, methyl-3,6-endomethylenetetrahydrophthalic anhydride, etc. Among these, dicyandiamide is preferably used. Since dicyandiamide has a small equivalent weight, it does not decrease the Si content of the silane modified resin composition so much, easily provides high heat resistance, and makes it possible to easily control the reaction rate.

Moreover, with respect to the epoxy resin blended in the silane modified phenolic resin composition, any of various known epoxy resins may be used. Examples thereof include: novolak type epoxy resins, such as o-cresol novolak type epoxy resins and phenol novolak type epoxy resins; glycidyl ester type epoxy resins derived from diglycidyl ether such as bisphenol A and bisphenol F; glycidyl ester type epoxy resins obtained by allowing polybasic acids such as phthalic acids and dimer acids, and epichlorohydrine to react with each other; glycidyl amine type epoxy resins obtained by allowing polyamines, such as diaminodiphenylmethane and isocyanuric acid, and epichlorohydrine to react with each other; and linear aliphatic epoxy resins and alicyclic epoxy resins obtained by oxidizing olefin bonds by using peracid such as peracetic acid. Here, one kind of these may be solely used, or not less than two kinds of them may be used in an appropriately combined manner. Moreover, the epoxy resin is preferably set to have an epoxy equivalent of 80 to 600. The epoxy equivalent exceeding 600 make it difficult to increase the Si content in the silane modified resin composition, resulting in a difficulty in obtaining high heat resistance, and it is difficult to form epoxy resins having an epoxy equivalent of less than 80. Moreover, the ratio of use of the epoxy curing agent is normally set in the range of 0.2 to 1.5 equivalent amounts of a functional group having active hydrogen in the curing agent with respect to one equivalent of an epoxy group in the epoxy resin.

Moreover, as described earlier, the silane modified resin composition may contain a curing catalyst for accelerating a setting reaction between the epoxy resin and the curing agent and hydrolyzing and condensing reactions of the methoxysilyl group. With respect to the curing catalyst, examples thereof include: tertiary amines, such as 1,8-diaza-bicyclo[5.4.0] undecene-7, triethylenediamine, benzyldimethylamine, triethanolamine, dimethylaminoethanol and tris(dimethylaminomethyl)phenol; imidazols such as 2-methylimidazol, 2-phenylimidazol, 2-phenyl-4-methylimidazol and 2-heptadecylimidazol; organic phosphines such as tributylphosphine, methyldiphenylphosphine, triphenylphosphine, diphenylphosphine and phenylphosphine; tetraphenyl boron salts such as tetraphenylphosphonium-tetraphenylborate, N-methylmorphorine-tetraphenylborate; and acids and bases or metallic catalysts used in normal sol-gel reactions. It is preferable to use the curing catalyst at the ratio of 0.01 to 5 parts by weight with respect to 100 parts by weight of the epoxy resin.

The silane modified resin composition is properly adjusted in its concentration by using a solvent. With respect to the solvent, the same solvent that has been used in the processes of the silane modified resin may be used.

Moreover, in an attempt to add interactive effects in improving the performances of the resulting cured product a silane coupling agent having an oxirane ring may be used for the silane modified resin composition. With respect to the silane coupling agent having an oxirane ring, examples thereof include 3-glycydoxypropyltrimethoxysilane and 3-glycydoxypropyltriethoxysilane, which are commercially available, and the application of this makes it possible to provide prepreg, etc. for printed wiring circuit boards that is superior in heat resistance.

Moreover, in order to improve properties such as a flame proof property, a low thermal expansion property and an additive plating property, inorganic particles may be added to the silane modified resin composition as a filler. The amount of addition of the inorganic particles is not particularly limited; however, it is preferably set in the range of 10 to 200 parts by weight with respect to 100 parts by weight of the silane modified resin composition. With respect to the inorganic particles, although not particularly limited, silica particles are preferably used from the viewpoint of the low thermal expansion property and additive plating property.

Here, it is preferable for the silane modified resin to have an Si content of 5 to 50 % by weight based upon silica weight conversion in its solid residual matter, and it is also preferable for the silane modified resin to have an Si content of 2 to 30 % by weight based upon silica weight conversion in the silane modified resin composition. The alkoxysilane partial condensate (2) can be converted to silica represented by the following general formula through a sol-gel setting reaction:

General formula: R1nSiO(4-n)/2

Here, with respect to the Si content based upon silica weight conversion in the solid residual matter is referred to as the silica indicated by % by weight, this is obtained as follows: That is, the alkoxysilyl portion of the silane modified resin has been set to form the silica through the sol-gel setting reaction. When the content of Si in the residual solid of the silane modified resin is less than 5 % by weight and the content of Si in the residual solid of the silane modified resin composition is also less than 2 % by weight, it becomes difficult to obtain high heat resistance. Moreover, when the content of Si in the residual solid of the silane modified resin exceeds 50 % by weight and the content of Si in the residual solid of the silane modified resin composition also exceeds 30 % by weight, there might be a reduction in the mechanical strength of the insulating material for printed wiring boards, and there also might be a reduction in the heat resistance since the reaction of the resin is unpreferably interrupted.

The alkoxy-group containing silane modified resin preferably used in the present invention is an alkoxy-group containing silane modified resin that is obtained through a reaction between a bisphenol type epoxy serving as the hydroxyl-group containing epoxy resin (A) and a methoxysilane partial condensate having an average number of Si of 2 to 20 per one molecule, serving as the alkoxysilane partial condensate (2).

Moreover, the alkoxy-group containing silane modified resin is virtually obtained by a reaction in a water-free system, and the content of Si in the residual solid in the silane modified resin composition is preferably set in the range of 5 to 50 % by weight based upon silica weight conversion.

Moreover, the silane modified resin composition, used in the present invention, contains the above-mentioned alkoxy-group containing silane modified resin, and also preferably contains dicyandiamide as an epoxy curing agent.

In addition, the silane modified resin composition, used in the present invention, is preferably set to contain silica in the range of 10 to 200 parts by weight with respect to 100 parts by weight of the residual solid of the alkoxy-group containing silane modified resin.

Alternatively, the alkoxy-group containing silane modified resin, used in the present invention, is preferably provided as an alkoxy-group containing silane modified resin obtained by a reaction between a novolak phenolic resin having an average number of phenolic units of 3 to 8 serving as the phenolic resin (B) and a methoxysilane partial condensate having an average number of Si of 2 to 20 per one molecule, serving as the alkoxysilane partial condensate (2).

Moreover, the alkoxy-group containing silane modified resin is virtually obtained by a reaction in a water-free system, and the content of Si in the residual solid in the silane modified resin composition is preferably set in the range of 5 to 50 % by weight based upon silica weight conversion.

Moreover, the silane modified resin composition, used in the present invention, contains the above-mentioned alkoxy-group containing silane modified resin, and also preferably contains an epoxy resin having an epoxy equivalent of 80 to 600.

In addition, the silane modified resin composition, used in the present invention, is preferably set to contain silica in the range of 10 to 200 parts by weight with respect to 100 parts by weight of the residual solid of the alkoxy-group containing silane modified resin.

In the present invention, the silane modified resin composition obtained as described above is used as an insulating material for printed wiring boards, and the insulating material for printed wiring boards of the present invention is used as a material for prepreg and CCL used for printed wiring boards, for resin coated copper foil and an insulating sheet used for build-up multi-layer PWB, or for a semiconductor interlayer insulating film.

The prepreg used for printed wiring boards refers to a B-stage (semi-cured state) prepreg that is obtained by impregnating a substrate with the insulating material for printed wiring boards made from the silane modified resin composition, drying this and then semi-curing this. With respect to this base plate, any of the known materials, such as inorganic fibers made from glass and asbestos, organic fibers made from polyamide and polyimide, and woven fabric and nonwoven fabric obtained by processing these, may be properly selected and used. Although not particularly limited, the manufacturing conditions of the prepreg are preferably set with a heating temperature of 60°C to 160°C and heating hours of 2 to 20 minutes. The heating temperature of less than 60°C fails to allow the silica setting at the alkoxysilyl portion of a methoxysilyl group to progress, resulting in tack even at normal temperature, and also raises volatile portions during a heating pressure molding process at the time of the application of the prepreg; therefore, this case is not preferable. In contrast, the heating temperature exceeding 160°C accelerates not only the silica setting reaction, but also most of the reaction of an oxirane ring and the curing agent, resulting in possible degradation in the moldability and adhering property at the time of laminating layers; therefore, this case is not preferable, either. The amount of use of the silane modified resin composition in the prepreg is not particularly limited; in general, it is preferable to set it in the range of 10 to 200 g/m² (converted based upon residual solid) per unit area of the prepreg.

Moreover, a metal clad laminate for printed wiring boards in the present invention refers to CCL obtained by pressure-molding under heat a laminated layer of one to ten sheets of the prepreg in the B-stage (semi-cured state), and this includes CCL with copper foil affixed on one surface or two surfaces thereof. The molding conditions of this laminated plate are, in general, preferably set in these ranges: 150°C to 300°C, 0.98 to 9.8 MPa (10 to 100 kg/cm²) and 30 to 200 minutes. Under these conditions, it is possible to easily obtain CCL having high heat resistance and low dielectric property, with sufficient mechanical strength. The molding temperature of less than 150°C fails to sufficiently set the oxirane ring; in contrast, the molding temperature exceeding 300°C allows the resin to start decomposing, resulting in degradation in the heat resistance and mechanical strength of the laminated plate. Moreover, in the case of the pressure of less than 0.98 MPa (10 kg/cm²) and that exceeding 9.8 MPa (100 kg/cm²), cracks and voids take place, resulting in a difficulty in providing good products.

Moreover, in the case of producing the semiconductor interlayer insulating film, the silane modified resin composition in the form of varnish is used as an insulating material for printed wiring boards, and this is applied onto a semiconductor by a spin coating method.

Furthermore in the case when resin coated copper foil used for build-up multi-layer PWB is manufactured, although not particularly limited, after an insulating material for printed wiring boards, made from the silane modified resin composition obtained as described above, has been applied onto copper foil, this is heated normally at a temperature of 60 to 160°C for 2 to 20 minutes so as to bring it to a semi-cured state; thus, the resin coated copper foil is obtained.

In the case when an insulating sheet used for build-up multi-layer PWB is manufactured, although not particularly limited, after an insulating material for printed wiring boards, made from the silane modified resin composition obtained as described above, has been applied onto a carrier film made from a mold-releasing material such as polyethyleneterephthalate, this is heated normally at a temperature of 60 to 160°C for 2 to 20 minutes so as to bring it to a semi-cured state; thus, the insulating sheet is obtained.

Moreover, in the case when an insulating film is formed by a varnish application on the build-up multi-layer plate, although not particularly limited, after an insulating material for printed wiring boards, made from the silane modified resin composition in the form of varnish obtained as described above, has been applied onto a substrate on which electric circuits are formed, this is heated normally at a temperature of 60 to 300°C for 5 to 200 minutes so as to cure it; thus, the insulating film is obtained. Thereafter, this is subjected to a roughing treatment by using a peroxide, and then further subjected to plating and etching processes; thus, a build-up circuit plate is prepared.

The following description will discuss the present invention by means of examples.

### (Example 1)

To 500 g of a silane modified resin ("HBEP-03", made by Arakawa Chemical Industries, Ltd.): dimethylformaldehyde solution having a residual solid resin component of 50 %; Si content of the residual solid = 25 % (converted based upon silica weight); epoxy equivalent 1270 g/eq), obtained by allowing a bisphenol A type epoxy resin having an epoxy equivalent of 480 to react with a tetramethoxysilane partial condensate having an average number of Si of 4 per molecule, was added 6.6 g of dicyandiamide, and sufficiently stirred to obtain a silane modified resin composition.

This silane modified resin composition was applied onto copper foil by using a barcoater, and this was then subjected to a heating treatment at 150°C for 3 minutes to obtain resin coated copper foil having an insulating layer with a thickness of 100 µm, made from the silane modified resin composition.

This resin coated copper foil was heated at 210 °C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 1 shows the results of the tests.

### (Example 2)

To 500 g of a silane modified resin ("HBEP-03", made by Arakawa Chemical Industries, Ltd.), obtained by allowing a bisphenol A type epoxy resin having an epoxy equivalent of 480 to react with a tetramethoxysilane partial condensate having an average number of Si of 4 per molecule, were added 41 g of phenol novolak resin (an average number of cores of 5; a phenolic hydroxyl group equivalent of 105) and 41 g of methylethylketone, and this was sufficiently stirred to obtain a silane modified resin composition.

This silane modified resin composition was applied onto copper foil by using a barcoater, and this was then subjected to a heating treatment at 150°C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 1 shows the results of the tests.

### (Example 3)

To 500 g of a silane modified resin ("HBP-11", made by Arakawa Chemical Industries, Ltd.): dimethylformamide solution having a residual solid resin component of 50 %; Si content of the residual solid = 32 % (converted based upon silica weight); a phenolic hydroxyl group equivalent of 625 g/eq), obtained by allowing a phenol novolak resin (an average number of cores of 5; a phenolic hydroxyl group equivalent of 106) to react with a tetramethoxysilane partial condensate having an average number of Si of 4 per molecule, was added 150 g of bisphenol A type epoxy resin having an epoxy equivalent of 190, and sufficiently stirred to obtain a silane modified resin composition.

This silane modified resin composition was applied onto copper foil by using a bar coater, and this was then subjected to a heating treatment at 150°C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 1 shows the results of the tests.

### (Example 4)

To 500 g of a silane modified resin ("HBP-11", made by Arakawa Chemical Industries, Ltd.), obtained by allowing a phenol novolak resin (an average number of cores of 5; a phenolic hydroxyl group equivalent of 106) to react with a tetramethoxysilane partial condensate having an average number of Si of 4 per molecule, were added 420 g of bisphenol A type epoxy resin having an epoxy equivalent of 480 and 420 g of methylethylketone, and sufficiently stirred to obtain a silane modified resin composition.

This silane modified resin composition was applied onto copper foil by using a barcoater, and this was then subjected to a heating treatment at 150°C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 1 shows the results of the tests.

### (Example 5)

To 500 g of a silane modified resin ("HBEP-03", made by Arakawa Chemical Industries, Ltd.), obtained as a dimethylformamide solution having a residual solid of 50 % by allowing a bisphenol A type epoxy resin having an epoxy equivalent of 480 to react with a tetramethoxysilane partial condensate having an average number of Si of 4 per molecule, were added 6.6 g of dicyandiamide and 60g of silica particles having an average particle size of 2 µm, and this was sufficiently stirred to obtain a silane modified resin composition.

This silane modified resin composition was applied onto copper foil by using a barcoater, and this was then subjected to a heating treatment at 150 °C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 1 shows the results of the tests.

### (Comparative Example 1)

A bisphenol A type epoxy resin (epoxy equivalent 480)(200 g), a phenol novolak resin (an average number of cores of 5; a phenolic hydroxyl group equivalent of 105)(44g), a tetramethoxysilane partial condensate (160 g) having an average number of Si per molecule of 4 and methylethylketone (200 g) were mixed and stirred to obtain a resin composition.

This resin composition was applied onto copper foil by using a barcoater, and this was then subjected to a heating treatment at 150°C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 1 shows the results of the tests.

**Table 1**

| silane modified resin | residual solid | Si content * | number of Si** | Example 1 | Example 2 | Example 3 | Example 4 | Example 5 | Comparative Example 1 |
|---|---|---|---|---|---|---|---|---|---|
| HBEP-03 | 50% | 25.0% | 4.0 | 500 | 500 | 500 | 500 | 500 | |
| HBP-11 | 50% | 32.0% | 4.0 | | | | | | |
| tetramethoxysilane partial condensate | | | | | | | | | 160 |
| bisphenol A type epoxy (equivalent of 480) | | | | | | | 420 | | 200 |
| bisphenol A type epoxy (equivalent of 190) | | | | | | 150 | | | |
| phenol novolak resin (equivalent of 105) | | | | | 41 | | | | 44 |
| dicyandiamide (equivalent of 21) | | | | 6.6 | | | | 6.6 | |
| methylethylketone | | | | | 41 | | 420 | | 200 |
| silica particles | | | | | | | | 60 | |
| total weight of silane modified resin composition | | | | 507 | 582 | 650 | 1340 | 567 | 604 |
| residual solid of silane modified resin composition | | | | 257 | 291 | 400 | 670 | 317 | 326 |
| Si content of silane modified resin composition*** | | | | 24.3% | 21.5% | 20.0% | 11.9% | 19.7% | 25.1% |
| weight % of silica particles of silane modified resin composition**** | | | | | | | | 10.6% | |
| Tg (method for measuring viscoelasticity) (°C) | | | | 159 | 153 | 174 | 147 | 153 | 150 |
| value of tan δ at above Tg | | | | 0.030 | 0.032 | 0.045 | 0.053 | 0.029 | 0.110 |
| bending elastic modulus (at 260°C) [pa] | | | | 1.7E+09 | 1.8E+09 | 1.5E+09 | 1.0E+09 | 1.8E+09 | 2.5E+08 |
| thermal expansion coefficient (40 - 80°C) [ppm/°C] | | | | 39 | 45 | 48 | 55 | 37 | 72 |
| thermal expansion coefficient (180 - 250°C) [ppm/°C] | | | | 112 | 121 | 132 | 156 | 105 | 264 |

| | | | | | | | | | |
|---|---|---|---|---|---|---|---|---|---|
| * Si content: Si content of the residual solid of silane modified resin composition converted based upon silica weight | | | | | | | | | |
| ** number of Si: average number of Si per molecule of alkoxysilane partial condensate used for silane modified resin | | | | | | | | | |
| *** Si content of silane modified resin composition: Si content of residual solid of silane modified resin composition converted based upon silica weight | | | | | | | | | |
| ****weight % of silica particles of silane modified resin composition: silica added as inorganic filler of residual solid of silane modified resin composition | | | | | | | | | |

As clearly indicated by Table 1, as compared with Comparative Example 1 using a resin composition obtained by adding an unreacted alkoxysilane partial condensate, the respective Examples using the silane modified resin composition of the present invention had a higher bending elastic modulus (at 260°C). Moreover, as compared with Comparative Example 1, the respective Examples had a lower thermal expansion coefficient.

### (Example 6)

To 500 g of a silane modified resin ("HBEP-03", made by Arakawa Chemical Industries, Ltd.), obtained by allowing a bisphenol A type epoxy resin having an epoxy equivalent of 480 to react with a tetramethoxysilane partial condensate having an average number of Si of 4 per molecule, was added 6.6 g of dicyandiamide, and sufficiently stirred to obtain a silane modified resin composition.

This silane modified resin composition was impregnated into glass cloth (MIL item number 2116 type), and this was dried at 120°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 2 shows the results of the tests.

### (Example 7)

To 500 g of a silane modified resin ("HBEP-03", made by Arakawa Chemical Industries, Ltd.), obtained by allowing a bisphenol A type epoxy resin having an epoxy equivalent of 480 to react with a tetramethoxysilane partial condensate having an average number of Si of 4 per molecule, were added 41 g of phenol novolak resin (an average number of cores of 5; a phenolic hydroxyl group equivalent of 105) and 41 g of methylethylketone, and this was sufficiently stirred to obtain a silane modified resin composition.

This silane modified resin composition was impregnated into glass cloth (MIL item number 2116 type), and this was dried at 120°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 2 shows the results of the tests.

### (Example 8)

To 500 g of a silane modified resin ("HBP-11", made by Arakawa Chemical Industries, Ltd.), obtained by allowing a phenol novolak resin (an average number of cores of 5; a phenolic hydroxyl group equivalent of 106) to react with a tetramethoxysilane partial condensate having an average number of Si of 4 per molecule, were added 150 g of bisphenol A type epoxy resin having an epoxy equivalent of 190, and sufficiently stirred to obtain a silane modified resin composition.

This silane modified resin composition was impregnated into glass cloth (MIL item number 2116 type), and this was dried at 140°C for 3 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 2 shows the results of the tests.

### (Example 9)

To 500 g of a silane modified resin ("HBP-11", made by Arakawa Chemical Industries, Ltd.), obtained by allowing a phenol novolak resin (an average number of cores of 5; a phenolic hydroxyl group equivalent of 106) to react with a tetramethoxysilane partial condensate having an average number of Si of 4 per molecule, were added 420 g of bisphenol A type epoxy resin having an epoxy equivalent of 480 and 420 g of methylethylketone, and sufficiently stirred to obtain a silane modified resin composition.

This silane modified resin composition was impregnated into glass cloth (MIL item number 2116 type), and this was dried at 140°C for 3 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 2 shows the results of the tests.

### (Example 10)

To 500 g of a silane modified resin ("HBEP-03", made by Arakawa Chemical Industries, Ltd.), obtained by allowing a bisphenol A type epoxy resin having an epoxy equivalent of 480 to react with a tetramethoxysilane partial condensate having an average number of Si of 4 per molecule, were added 6.6 g of dicyandiamide and 60g of silica particles having an average particle size of 2 µ m, and this was sufficiently stirred to obtain a silane modified resin composition.

This silane modified resin composition was impregnated into glass cloth (MIL item number 2116 type), and this was dried at 120°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260 °C obtained by a viscoelasticity spectrum meter, the thermal expansion coefficient was evaluated by using a tensile TMA, and the flame proof property was evaluated by using a UL method. Table 2 shows the results of the tests.

### (Comparative Example 2)

A bisphenol A type epoxy resin (epoxy equivalent 480)(200 g), a phenol novolak resin (an average number of cores of 5; a phenolic hydroxyl group equivalent of 105)(44g), a tetramethoxysilane partial condensate (160 g) having an average number of Si of 4 per molecule and methylethylketone (200 g) were mixed and stirred to obtain a resin composition.

This resin composition was impregnated into glass cloth (MIL item number 2116 type), and this was dried at 150°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 2 shows the results of the tests.

**Table 2**

| | Example 6 | Example 7 | Example 8 | Example 9 | Example 10 | Comparative Example 2 |
|---|---|---|---|---|---|---|
| resin blending | same as Example 1 | Same as Example 2 | same as Example 3 | same as Example 4 | same as Example 5 | same as Comparative Example 1 |
| base plate used (MIL style) | 2116 | 2116 | 2116 | 2116 | 2116 | 2116 |
| drying condition | at 120°C for 4 minutes | at 120°C for 4 minutes | at 120°C for 3 minutes | at 120°C for 3 minutes | at 120°C for 4 minutes | at 150°C for 4 minutes |
| adhesive strength of copper foil [Kg/cm] | 1.38 | 1.41 | 1.43 | 1.40 | 1.31 | 1.40 |
| bending elastic modulus (at 260°C) [pa] | 4.5E+09 | 3.7E+09 | 3.1E+09 | 2.2E+09 | 4.1E+09 | 6.0E+08 |
| thermal expansion coefficient (at 40 to 80°C) [ppm/°C] | 43 | 48 | 50 | 52 | 39 | 76 |
| thermal expansion coefficient (at 180 to 250°C) [ppm/°C] | 120 | 125 | 133 | 139 | 112 | 278 |
| flame proof property (UL method) | V-0 | V-0 | V-0 | V-0 | V-0 | V-1 |

As clearly indicated by Table 2, as compared with Comparative Example 2 using a resin composition obtained by adding an unreacted alkoxysilane partial condensate, the respective Examples using the silane modified resin composition of the present invention had a higher bending elastic modulus (at 260°C). Moreover, as compared with Comparative Example 2, the respective Example had a lower thermal expansion coefficient. Here, although the adhesive strength of the respective Examples was virtually similar to that of Comparative Example, the flame proof property was improved.

### (Example 11)

To 500 g of a silane modified resin ("HBEP-08", made by Arakawa Chemical Industries, Ltd.): dimethylformamide solution having a residual solid resin component of 50 %; Si content of the residual solid = 25 % (converted based upon silica weight); an epoxy equivalent of 509), obtained by allowing a bisphenol A type epoxy resin having an epoxy equivalent of 190 to react with a tetramethoxysilane partial condensate having an average number of Si of 4 per molecule, was added 20.6 g of dicyandiamide, and sufficiently stirred to obtain a silane modified resin composition.

This silane modified resin composition was applied onto copper foil by using a barcoater, and this was then subjected to a heating treatment at 150°C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 3 shows the results of the tests.

### (Example 12)

To 500 g of a silane modified resin ("HBEP-08", made by Arakawa Chemical Industries, Ltd.), obtained by allowing a bisphenol A type epoxy resin having an epoxy equivalent of 190 to react with a tetramethoxysilane partial condensate having an average number of Si of 4 per molecule, were added 103 g of phenol novolak resin (an average number of cores of 5; a phenolic hydroxyl group equivalent of 105) and 103 g of methylethylketone, and this was sufficiently stirred to obtain a silane modified resin composition.

This silane modified resin composition was applied onto copper foil by using a barcoater, and this was then subjected to a heating treatment at 150° C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 3 shows the results of the tests.

### (Example 13)

To 500 g of a silane modified resin ("HBP-20", made by Arakawa Chemical Industries, Ltd.): methylethylketone solution having a residual solid resin component of 65 %; Si content of the residual solid = 32 % (converted based upon silica weight); a phenolic hydroxyl group equivalent of 351 g/eq), obtained by allowing a phenol novolak resin (an average number of cores of 5; a phenolic hydroxyl group equivalent of 106) to react with a methyltrimethoxysilane partial condensate having an average number of Si of 5.6 per molecule, was added 270 g of a bisphenol A type epoxy resin having an epoxy equivalent of 190, and this was sufficiently stirred to obtain a silane modified resin composition.

This silane modified resin composition was applied onto copper foil by using a barcoater, and this was then subjected to a heating treatment at 150° C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 3 shows the results of the tests.

### (Example 14)

To 500 g of a silane modified resin ("HBP-20", made by Arakawa Chemical Industries, Ltd.), obtained by allowing a phenol novolak resin (an average number of cores of 5; a phenolic hydroxyl group equivalent of 106) to react with a methyltrimethoxysilane partial condensate having an average number of Si of 5.6 per molecule, was added 680 g of a bisphenol A type epoxy resin having an epoxy equivalent of 480, and this was sufficiently stirred to obtain a silane modified resin composition.

This silane modified resin composition was applied onto copper foil by using a barcoater, and this was then subjected to a heating treatment at 150°C for 3 minutes to obtain resin coated copper foil having an insulating layer with a thickness of 100µ m, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 3 shows the results of the tests.

### (Example 15)

To 500 g of a silane modified resin ("HBEP-08", made by Arakawa Chemical Industries, Ltd.), obtained by allowing a bisphenol A type epoxy resin having an epoxy equivalent of 190 to react with a tetramethoxysilane partial condensate having an average number of Si of 4 per molecule, were added 20.6 g of dicyandiamide and 60 g of silica particles having an average particle size of 2 µm, and this was sufficiently stirred to obtain a silane modified resin composition.

This silane modified resin composition was applied onto copper foil by using a barcoater, and this was then subjected to a heating treatment at 150°C for 3 minutes to obtain resin coated copper foil having an insulating layer with a thickness of 100 µm, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 3 shows the results of the tests.

### (Comparative Example 3)

A bisphenol A type epoxy resin (epoxy equivalent 480)(200 g), a phenol novolak resin (an average number of cores of 5; a phenolic hydroxyl group equivalent of 105)(44g), a tetramethoxysilane partial condensate (160 g) having an average number of Si of 4 per molecule, 60 g of silica particles having an average particle size of 2 *µ* m and methylethylketone (200 g) were mixed and stirred to obtain a varnish.

This varnish was applied onto copper foil by using a barcoater, and this was then subjected to a heating treatment at 150°C for 3 minutes to obtain resin coated copper foil having an insulating layer with a thickness of 100µ m, made from the silane modified resin composition.

This resin coated copper foil was heated at 210°C for 2 hours so that it was completely cured, and the copper foil was then etched. This was measured in its elastic modulus at 260°C by using a viscoelasticity spectrum meter so as to evaluate its heat resistance, and its thermal expansion coefficient was evaluated by using a tensile TMA. Table 3 shows the results of the tests.

**Table 3**

| silane modified resin | residual solid | Si content* | number of Si** | Example 11 | Example 12 | Example 13 | Example 14 | Example 15 | Comparative Example 3 |
|---|---|---|---|---|---|---|---|---|---|
| HBEP-08 | 50% | 25% | 4.0 | 500 | 500 | | | 500 | |
| HBP-20 | 50% | 32% | 5.6 | | | 500 | 500 | | |
| tetramethoxysilane partial condensate | | | | | | | | | 160 |
| bisphenol A type epoxy (equivalent of 480) | | | | | | | 680 | | 200 |
| bisphenol A type epoxy (equivalent of 190) | | | | | | 270 | | | |
| phenol novolak resin (equivalent of 105) | | | | | 103 | | | | 44 |
| dicyandiamide (equivalent of 21) | | | | 20.6 | | | | 20.6 | |
| methylethylketone | | | | | 103 | | 680 | | 200 |
| silica particles | | | | | | | | 60 | 60 |
| total weight of silane modified resin composition | | | | 521 | 706 | 770 | 1860 | 581 | 664 |
| residual solid of silane modified resin composition | | | | 271 | 353 | 595 | 1005 | 331 | 385 |
| Si content of silane modified resin composition*** weight % of silica particles of silane modified resin composition**** | | | | 23.1% | 17.7% | 17.5% | 10.3% | 18.9% 18.0% | 21.2% 15.6% |
| Tg (method for measuring viscoelasticity) (°C) | | | | 168 | 163 | 186 | 150 | 171 | 151 |
| value of tan δ at above Tg | | | | 0.049 | 0.057 | 0.065 | 0.071 | 0.034 | 0.130 |
| bending elastic modulus (at 260°C) [pa] | | | | 1.1E+09 | 1.4E+09 | 8.9E+08 | 6.7E+08 | 1.3E+09 | 2.5E+08 |
| thermal expansion coefficient (at 40 to 80°C) [ppm/°C] | | | | 44 | 48 | 60 | 62 | 40 | 67 |
| thermal expansion coefficient (at 180 to 250°C) [ppm/°C] | | | | 125 | 133 | 140 | 161 | 110 | 248 |

| | | | | | | | | | |
|---|---|---|---|---|---|---|---|---|---|
| * Si content: Si content of the residual solid of silane modified resin composition converted based upon silica weight | | | | | | | | | |
| ** number of Si: average number of Si per molecule of alkoxysilane partial condensate used for silane modified resin | | | | | | | | | |
| *** Si content of silane modified resin composition: Si content of residual solid of silane modified resin composition converted based upon silica weight | | | | | | | | | |
| **** weight % of silica particles of silane modified resin composition: silica added as inorganic filler of residual solid of silane modified resin composition | | | | | | | | | |

As clearly indicated by Table 3, as compared with Comparative Example 1 using a resin composition obtained by adding an unreacted alkoxysilane partial condensate and Comparative Example 3 further containing silica particles, the respective Examples using the silane modified resin composition of the present invention had a higher bending elastic modulus (at 260°C). Moreover, as compared with Comparative Example 1 and Comparative Example 3, the respective Examples had a lower thermal expansion coefficient, and it was confirmed that the respective Examples made it possible to reduce the thermal expansion coefficient as compared with a case in which only silica particles were mixed.

### (Example 16)

To 500 g of a silane modified resin ("HBEP-08", made by Arakawa Chemical Industries, Ltd.), obtained by allowing a bisphenol A type epoxy resin having an epoxy equivalent of 190 to react with a tetramethoxysilane partial condensate having an average number of Si of 4 per molecule, was added 20.6 g of dicyandiamide, and this was sufficiently stirred to obtain a silane modified resin composition.

This silane modified resin composition was impregnated into glass cloth (MIL item number 2116 type), and this was dried at 120°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 4 shows the results of the tests.

### (Example 17)

To 500 g of a silane modified resin ("HBEP-08", made by Arakawa Chemical Industries, Ltd.), obtained by allowing a bisphenol A type epoxy resin having an epoxy equivalent of 190 to react with a tetramethoxysilane partial condensate having an average number of Si of 4 per molecule, were added 103 g of phenol novolak resin (an average number of cores of 5; a phenolic hydroxyl group equivalent of 105) and 103 g of methylethylketone, and this was sufficiently stirred to obtain a silane modified resin composition.

This silane modified resin composition was impregnated into glass cloth (MIL item number 2116 type), and this was dried at 120°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 4 shows the results of the tests.

### (Example 18)

To 500 g of a silane modified resin ("HBP-20", made by Arakawa Chemical Industries, Ltd.), obtained by allowing a phenol novolak resin (an average number of cores of 5; a phenolic hydroxyl group equivalent of 106) to react with a methyltrimethoxysilane partial condensate having an average number of Si of 5.6 per molecule, was added 270 g of a bisphenol A type epoxy resin having an epoxy equivalent of 190, and this was sufficiently stirred to obtain a silane modified resin composition.

This silane modified resin composition was impregnated into glass cloth (MIL item number 2116 type), and this was dried at 140°C for 3 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 4 shows the results of the tests.

### (Example 19)

To 500 g of a silane modified resin ("HBP-20", made by Arakawa Chemical Industries, Ltd.), obtained by allowing a phenol novolak resin (an average number of cores of 5; a phenolic hydroxyl group equivalent of 106) to react with a methyltrimethoxysilane partial condensate having an average number of Si of 5.6 per molecule, was added 680 g of a bisphenol A type epoxy resin having an epoxy equivalent of 480, and this was sufficiently stirred to obtain a silane modified resin composition.

This silane modified resin composition was impregnated into glass cloth (MIL item number 2116 type), and this was dried at 140°C for 3 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 4 shows the results of the tests.

### (Example 20)

To 500 g of a silane modified resin ("HBEP-08", made by Arakawa Chemical Industries, Ltd.), obtained by allowing a bisphenol A type epoxy resin having an epoxy equivalent of 190 to react with a tetramethoxysilane partial condensate having an average number of Si of 4 per molecule, were added 20.6 g of dicyandiamide and 60 g of silica particles having an average particle size of 2 µm, and this was sufficiently stirred to obtain a silane modified resin composition.

This silane modified resin composition was impregnated into glass cloth (MIL item number 2116 type), and this was dried at 120°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200 °C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 4 shows the results of the tests.

### (Comparative Example 4)

A bisphenol A type epoxy resin (epoxy equivalent 480)(200 g), a phenol novolak resin (an average number of cores of 5; a phenolic hydroxyl group equivalent of 105)(44g), a tetramethoxysilane partial condensate (160 g) having an average number of Si of 4 per molecule, 60 g of silica particles having an average particle size of 2µm and methylethylketone (200 g) were mixed and stirred to obtain a varnish.

This varnish was impregnated into glass cloth (MIL item number 2116 type), and this was dried at 150°C for 4 minutes to obtain prepreg in a B-stage (semi-cured state). Then, eight sheets of the prepreg were superposed on each other, and pieces of copper foil having a thickness of 18 µm were affixed on the upper and bottom surfaces thereof. This was then heated and pressed at 200°C under 2.94 MPa (30 kg/cm²) for two hours to obtain CCL with copper foil.

The adhesive property of the copper foil of this laminated plate was evaluated. Moreover, with respect to the laminated plate with etched copper foil, the heat resistance thereof was evaluated by its elastic modulus at 260°C obtained by a viscoelasticity spectrum meter, the thermal expansion coefficient was evaluated by using a tensile TMA, and the flame proof property was evaluated by using a UL method. Table 4 shows the results of the tests.

**[Table 4]**

| | Example 16 | Example 17 | Example 18 | Example 19 | Example 20 | Comparative Example 4 |
|---|---|---|---|---|---|---|
| resin blending | same as Example 11 | same as Example 12 | same as Example 13 | same as Example 14 | same as Example 15 | same as Comparative Example 3 |
| base plate used (MIL style) | 2116 | 2116 | 2116 | 2116 | 2116 | 2116 |
| drying condition | at 120°C for 4 minutes | at 120°C for 4 minutes | at 120°C for 4 minutes | at 120°C for 4 minutes | at 120°C for 4 minutes | at 120°C for 4 minutes |
| adhesion strength of copper foil [Kg/cm] | 1.42 | 1.37 | 1.51 | 1.38 | 1.35 | 1.32 |
| bending elastic modulus (at 260°C) [pa] | 4.1E+09 | 3.0E+09 | 4.4E+09 | 2.0E+09 | 5.3E+09 | 7.5E+08 |
| thermal expansion coefficient (40 - 80°C) [ppm/°C] | 50 | 53 | 47 | 51 | 43 | 65 |
| thermal expansion coefficient (180 - 250°C) [ppm/°C] | 124 | 129 | 128 | 130 | 120 | 264 |
| flame proof property (UL method) | V-0 | V-0 | V-0 | V-0 | V-0 | V-1 |

As clearly indicated by Table 4, as compared with Comparative Example 2 using a resin composition obtained by adding an unreacted alkoxysilane partial condensate and Comparative Example 4 further containing silica particles, the respective Examples using the silane modified resin composition of the present invention had a higher bending elastic modulus (at 260°C). Moreover, as compared with Comparative Example 2 and Comparative Example 4, the respective Examples had a lower thermal expansion coefficient, and it was confirmed that the respective Examples made it possible to reduce the thermal expansion coefficient as compared with a case in which only silica particles were mixed. Although the adhesive property of the respective Examples is virtually the same as that of Comparative Examples, the flame proof property was improved.

The following description will discuss evaluation methods of the Examples in detail.

### (1) Heat resistance

Based upon the JIS standard C6481, test pieces, each having a short side of 5 ± 0.5 mm and a long side of not less than 50 mm with a thickness in the laminating direction, were formed from the resin coated copper foil or the laminated plate with copper foil of the above-mentioned Examples and Comparative Examples. With respect to each of the test pieces, the bending strength (N/mm²) in the laminating direction was measured at 260°C by using a viscoelasticity spectrum meter, and based upon this, the elastic modulus (unit: Pa) was calculated, and the heat resistance was evaluated.

### (2) Thermal expansion coefficient

Based upon the JIS standard C6493, test pieces were formed from the resin coated copper foil or the laminated plate with copper foil of the above-mentioned Examples and Comparative Examples. With respect to each of the test pieces, the thermal expansion coefficients (unit: ppm/°C) were measured at 40 to 80°C as well as at 180 to 250°C by using a tensile TMA method.

### (3) Adhesive property

Based upon the JIS standard C6481, test pieces, each of which has a copper foil portion measuring 10 ± 0.1 mm X 100 mm that was formed in the center in the width direction of a prepreg laminated portion by using etching, etc. with the laminating direction coinciding with the thickness direction, were formed from the laminated plates with copper foil of the above-mentioned Examples and Comparative Examples. With respect to each of the test pieces, one of the ends of the copper foil portion was pulled at a rate of 50 mm/minute in the vertical direction with respect to the surface of the prepreg laminated portion so that the peeling strength (unit: kgf/cm) was measured.

### (4) Flame proof property

With respect to the laminated plates with copper foil of the above-mentioned Examples and Comparative Examples, virtical burning tests were carried out based upon the UL method (subject 94); thus, the flame proof property was evaluated.

### EFFECTS OF THE INVENTION

As described above, the insulating material for printed wiring boards of the present invention is provided with: a silane modified resin composition containing an alkoxy-group containing silane modified resin obtained by a reaction between a hydroxyl-group containing resin that is at least one kind selected from the group consisting of a hydroxyl-group containing epoxy resin (A) and a phenolic resin (B) and an alkoxysilane partial condensate; therefore, it is possible to provide a material that has a high bending elastic modulus at the time of heating with high heat resistance, and also has a low thermal expansion coefficient with superior flame proof property.

Here, a bisphenol-type epoxy resin is used as the hydroxyl-group containing epoxy resin (A); thus, since the bisphenol-type epoxy resin, which is widely used as electric and electronic apparatuses, communication apparatuses and computers, is adopted, this resin can be widely used as a material for printed wiring boards for general purposes, and can also provide superior properties such as high heat resistance.

Moreover, in the case when a novolak phenolic resin is adopted as the phenolic resin (B), since the novolak phenolic resin has a small phenol equivalent and is multi-functional so that it increases the number of bonds between silane and hydroxyl groups and allows several hydroxyl groups to remain even after the silane has been modified, and to still react with other resins; thus, it is possible to obtain high heat resistance and low thermal expansion property.

Moreover, the application of a novolack phenolic resin having an average number of phenolic units of approximately 3 to 8 as the phenolic resin (B) makes it possible to obtain high heat resistance without the problem of gelation.

Furthermore, the alkoxysilane partial condensate (2) is allowed to have an average number of Si in a range of 2 to 20 per molecule thereof; thus, it is possible to obtain a high reactivity in the ester exchange reaction with the hydroxyl-group containing resin, and consequently to easily prepare the alkoxy-group containing silane modified resin.

Here, in the case when a methoxysilane partial condensate is adopted as the alkoxysilane partial condensate (2), since the methoxysilane partial condensate has high ester exchange reaction rate and setting reaction rate, it is possible to easily prepare the alkoxy-group containing silane modified resin.

Moreover, the alkoxy-group containing silane modified resin is allowed to have a residual solid whose Si content is set in a range of 5 to 50 weight % based upon silica weight conversion; thus, it becomes possible to obtain high heat resistance without a reduction in the strength.

Furthermore, the alkoxy-group containing silane modified resin is virtually obtained through a water-free reaction; thus, the alkoxysilyl portion is allowed to react without causing a sol-gel setting reaction in obtaining an alkoxy-group containing silane modified resin. Consequently, it is possible to improve the storing stability and easiness in handling of the silane modified resin.

Here, the silane modified resin composition has a residual solid whose Si content is set in a range of 2 to 30 weight % based upon silica weight conversion; thus, it becomes possible to obtain high heat resistance without a reduction in the strength.

Moreover, the silane modified resin composition, which contains an alkoxy-group containing silane modified resin obtained by a reaction between a hydroxyl-group containing epoxy resin (A) and an alkoxysilane partial condensate (2), is allowed to contain a curing catalyst and/or an epoxy curing agent; therefore, the silane modified resin composition is prepared as an epoxy resin varnish so that prepreg and CCL can be manufactured through the same drying and molding processes as those generally taken in the case of the epoxy resin varnish.

Furthermore, in the case when dicyandiamide is used as the epoxy curing agent, since dicyandiamide has a small equivalent weight and since it consequently does not decrease the Si content of the silane modified resin composition so much, it is possible to easily provide high heat resistance, and also to easily control the reaction rate.

Moreover, the silane modified resin composition, which contains an alkoxy-group containing silane modified resin obtained by a reaction between a phenolic resin (B) and an alkoxysilane partial condensate (2), is allowed to contain an epoxy resin; therefore, the silane modified resin composition is prepared as an epoxy resin varnish so that prepreg and CCL can be manufactured through the same drying and molding processes as those generally taken in the case of the epoxy resin varnish.

Moreover, the application of an epoxy resin having an epoxy equivalent of 80 to 600 as the aforementioned epoxy resin makes it possible to easily obtain high heat resistance.

Furthermore, the addition of inorganic particles in a range of 10 to 200 parts by weight with respect to 100 parts by weight of the alkoxy-group containing silane modified resin makes it possible to improve the flame proof property and also to reduce the thermal expansion coefficient.

Here, the application of silica as the inorganic particles makes it possible to further reduce the thermal expansion coefficient, and also to improve the additive plating property.

## Claims

1. An insulating material for printed wiring boards **characterized by** comprising: a silane modified resin composition containing an alkoxy-group containing silane modified resin obtained by a reaction between a hydroxyl-group containing resin (1) that is at least one kind selected from the group consisting of a hydroxyl-group containing epoxy resin (A) and a phenolic resin (B) and an alkoxysilane partial condensate (2).

2. The insulating material for printed wiring boards according to claim 1, **characterized in that** said hydroxyl-group containing epoxy resin (A) is a bisphenol-type epoxy resin.

3. The insulating material for printed wiring boards according to claim 1, **characterized in that** said phenolic resin (B) is a novolak phenolic resin.

4. The insulating material for printed wiring boards according to claim 3, **characterized in that** said phenolic resin (B) is a novolak phenolic resin having an average phenolic unit number of 3 to 8.

5. The insulating material for printed wiring boards according to claim 1, **characterized in that** said alkoxysilane partial condensate (2) has an average number of Si in a range of 2 to 20 per one molecule thereof.

6. The insulating material for printed wiring boards according to claim 1, **characterized in that** said alkoxysilane partial condensate (2) is a methoxysilane partial condensate.

7. The insulating material for printed wiring boards according to claim 1, **characterized in that** said alkoxy-group containing silane modified resin has a residual solid whose Si content is set in a range of 5 to 50 weight % based upon silica weight conversion.

8. The insulating material for printed wiring boards according to claim 1, **characterized in that** said alkoxy-group containing silane modified resin is virtually obtained through a anhydrous reaction.

9. The insulating material for printed wiring boards according to claim 1, **characterized in that** said silane modified resin composition has a residual solid whose Si content is set in a range of 2 to 30 weight % based upon silica weight conversion.

10. The insulating material for printed wiring boards according to claim 1, **characterized in that** said silane modified resin composition containing an alkoxy-group containing silane modified resin obtained by a reaction between a hydroxyl-group containing epoxy resin (A) and an alkoxysilane partial condensate (2) is allowed to contain a curing catalyst and/or an epoxy curing agent.

11. The insulating material for printed wiring boards according to claim 10, **characterized in that** said epoxy curing agent is dicyandiamide.

12. The insulating material for printed wiring boards according to claim 1, **characterized in that** said silane modified resin composition containing an alkoxy-group containing silane modified resin obtained by a reaction between a phenolic resin (B) and an alkoxysilane partial condensate (2) is allowed to contain an epoxy resin.

13. The insulating material for printed wiring boards according to claim 12, **characterized in that** said epoxy resin has an epoxy equivalent of 80 to 600.

14. The insulating material for printed wiring boards according to claim 1, **characterized in that** said silane modified resin composition contains inorganic particles in a range of 10 to 200 parts by weight with respect to 100 parts by weight of a residual solid of the alkoxy-group containing silane modified resin.

15. The insulating material for printed wiring boards according to claim 14, **characterized in that** said inorganic particles are silica.

16. The insulating material for printed wiring boards according to claim 1, **characterized in that** said alkoxy-group containing silane modified resin is an alkoxy-group containing silane modified resin obtained through a reaction between a bisphenol-type epoxy resin serving as the hydroxyl-group containing epoxy resin (A) and a methoxysilane partial condensate having an average number of Si of 2 to 20 per molecule serving as the alkoxysilane partial condensate.

17. The insulating material for printed wiring boards according to claim 1, **characterized in that** said alkoxy-group containing silane modified resin is an alkoxy-group containing silane modified resin obtained through a reaction between a novolak phenolic resin having an average phenolic units of 3 to 8 as the phenolic resin (B) and a methoxysilane partial condensate having an average number of Si of 2 to 20 per molecule as the alkoxysilane partial condensate.

18. The insulating material for printed wiring boards according to claim 16, **characterized in that** said alkoxy-group containing silane modified resin is virtually obtained through a water-free reaction, and the silane modified resin composition has a residual solid whose Si content is set in a range of 5 to 50 weight % based upon silica weight conversion.

19. The insulating material for printed wiring boards according to claim 17, **characterized in that** said alkoxy-group containing silane modified resin is virtually obtained through a water-free reaction, and has a residual solid whose Si content is set in a range of 5 to 50 weight % based upon silica weight conversion.

20. The insulating material for printed wiring boards according to claim 18, **characterized in that** said silane modified resin composition contains dicyandiamide as the epoxy curing agent.

21. The insulating material for printed wiring boards according to claim 19, **characterized in that** said silane modified resin composition contains an epoxy resin having an epoxy equivalent of 80 to 600.

22. The insulating material for printed wiring boards according to claim 20, **characterized in that** said silane modified resin composition contains silica in a range of 10 to 200 parts by weight with respect to 100 parts by weight of a residual solid of the alkoxy-group containing silane modified resin.

23. The insulating material for printed wiring boards according to claim 21, **characterized in that** said silane modified resin composition contains silica in a range of 10 to 200 parts by weight with respect to 100 parts by weight of a residual solid of the alkoxy-group containing silane modified resin.
